# EUROPEAN PATENT SPECIFICATION

(11) **EP 2 672 798 B1**
(45) Date of publication and mention of the grant of the patent: **19.08.2020**
(21) Application number: 13169613.0
(22) Date of filing: 29.05.2013
(51) Int. Cl.: H05K 7/20

(54) **Compact two sided cold plate with floating transfer tubes**
Kompakte zweiseitige Kühlplatte mit schwimmenden Übertragungsröhren
Plaque froide à deux faces compactes avec des tubes de transfert flottants

(30) Priority: 07.06.2012 US 201213490564
(43) Date of publication of application: 11.12.2013
(73) Proprietor: Hamilton Sundstrand Space Systems International, Inc., Windsor Locks, CT 06096 (US)
(72) Inventor: ZAFFETTI, Mark A., Suffield, CT Connecticut 06078 (US)
(74) Representative: Dehns

(56) References cited:
- EP-A2- 2 372 290
- EP-A2- 2 372 760

## Description

### BACKGROUND

This disclosure generally relates to a cooling structure for cooling electronic components. More particularly, this disclosure relates to a cooling structure including a two sided cold plate support assembly.

Electronic components onboard aircraft or other vehicles that operate in extreme temperatures are typically protected from overheating by a cooling device.

The publications EP2372760 and EP2372290 disclose such devices.

In some environments, air flow is either not available or insufficient to handle the thermal loads generated by the electronic components. In such applications, a cold plate is utilized through which a cooling fluid flows to remove heat from the electronic component. The cold plate is mounted adjacent the electronic component and supplied with fluid flow through appropriate conduits that lead to a fluid delivery system.

### SUMMARY

A disclosed structural cold plate assembly includes cold plates mounted to opposing sides of a panel and in fluid communication through fluid passages through the panel. The disclosed structural cold plate assembly includes floating tubes that define a passage for fluid from one cold plate on one side of the panel to another cold plate on an opposing side of the panel. The disclosed tubes accommodate vibratory movement along with defining the passages that provide for fluid communication of a cooling medium between the cold plates and through the structural panel.

These and other features disclosed herein can be best understood from the following specification and drawings, the following of which is a brief description.

### BRIEF DESCRIPTION OF THE DRAWINGS

Figure 1 is a schematic view of a structural cold plate assembly.
Figure 2 is a sectional view of the example cold plate assembly.
Figure 3 is an exploded view of another example cold plate assembly.
Figure 4 is a perspective view of an example transfer tube.
Figure 5 is a cross-section of the example transfer tube.

### DETAILED DESCRIPTION

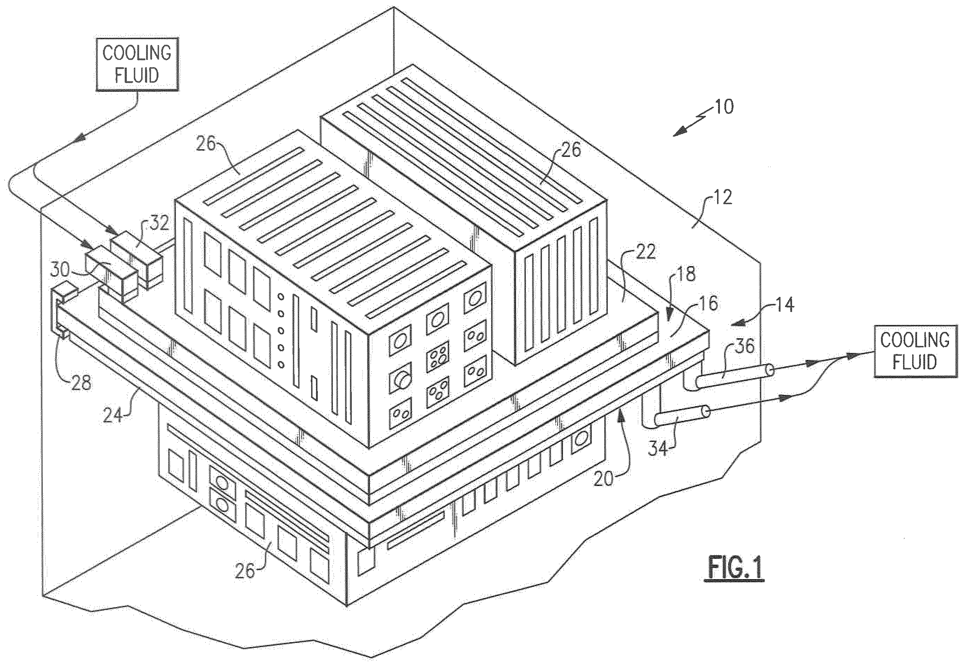

Referring to Figure 1, an example support assembly 10 includes a fixed structure 12 that supports a structural cold plate assembly 14 for thermally controlling and cooling heat generating devices 26. In the disclosed example, the heat generating devices 26 are electronic devices that generate heat during operation. As appreciated, although electronic devices are described as examples, the disclosed structural cold plate assembly 14 would be useful for any application requiring thermal management.

The example structural cold plate assembly 14 includes a panel 16 that includes a first side 18 and a second side 20. Mounted to the first side 18 is a first cold plate 22 and mounted to the second side 20 is a second cold plate 24. Each of the first and second cold plates 22, 24 define passages through which a cooling medium flows to remove and control heat produced by the devices 26. The panel 16 and thereby the first and second cold plates 22, 24 are supported by at least one mount 28 to the fixed structure 12. The fixed structure 12 could be a cabinet, wall, bulkhead or other fixed structure that provides a desired location for the devices 26. Moreover, although cold plates 22, 24 are disclosed by way of example, any heat exchanging device could also be utilized and would benefit from the example disclosures.

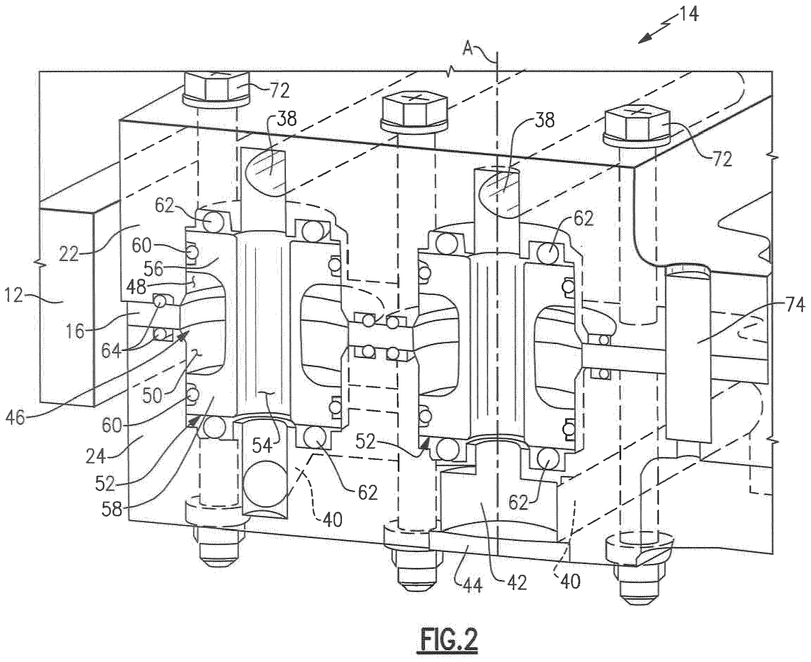

The first and second cold plates 22, 24 include passages or circuits (Shown in Figure 2) through which the cooling medium flows to remove heat generated by the devices 26. The devices 26 are mounted in thermal contact with each of the cold plates 22, 24 such that thermal energy is transferred to the fluid medium. In the disclosed example, the devices 26 are mounted on the corresponding cold plate 22, 24. However, other mounting configurations that place the cold plate in thermal contact with the devices 26 are within the contemplation of this disclosure.

The cooling medium is supplied by the first and second inlets 30, 32 that are mounted to the first cooling plate 22. The cooling medium can include a cooling fluid, air, or gas along with a combination of fluid, air and gas that facilitate the removal of heat generated by the devices 26. In this example the cooling plates 22, 24 each include two separate cooling circuits and therefore two inlets 30, 32 are provided. The cooling medium is then directed through passages (Figure 2) through the panel 16 to the second cooling plate 24. The second cooling plate 24 includes first and second outlets 34 and 36 that direct the cooling medium through other portions of cooling circulation system.

As appreciated, the cooling system may include a heat exchanger to dissipate heat absorbed by the cooling medium and a pump to power circulation of the cooling medium. Moreover, the example structural cold plate assembly 14 provides for the use of different cooling mediums such as different types of fluid in each of the separate circuits to provide desired thermal control capabilities. Further, although the example structural cooling plate assembly 14 includes two separate cooling circuits, one or more than two cooling circuits are also within the contemplation for use with the disclosed device.

Referring to Figure 2, the example cold plate assembly 14 includes a bore 46 that is defined within the first cold plate 22, the second cold plate 24, and the panel 16. The first cold plate 22 includes the passages 38 that communicate with the bore 46. The second cold plate 24 includes passages 40 that communicate with the bore 46. The second cold plate 24 also includes a cavity 42 that is also in communication with the cooling passages 40. The example cavity 42 is disposed along an axis A of the bore 46 and includes a cap 44 that closes off the cavity 42. As appreciated, although several example cooling passages 38, 40 are illustrated within the example cold plates 22, 24, other passages and configurations are disposed throughout each cold plate 22, 24 and other configurations are within the contemplation of this disclosure.

The example bore 46 includes a portion 48 defined within the first cold plate 22 and a portion 50 defined within the second cold plate 24. The bore 46 defines a passage between the first cold plate 22 and the second cold plate 24 through the panel 16. As appreciated, in some applications that cold plate assembly 14 encounters and experiences a great deal of vibration. Vibrations can disrupt fixed members attached between separate structures. Accordingly, passages between the example first and second cold plates 22, 24 include conduits that accommodate vibrational effects.

Disposed within each of the bores 46 is a transfer tube 52. The transfer tube 52 is movable within the bore 46 to accommodate vibrational movement between the cold plates 22, 24 and the panel 16. The transfer tubes 52 are movable but are not moved between specific positions. Instead the transfer tubes 52 are suspended within the bore 46 in a desired position between biasing members 62. In this example, the biasing members 62 comprise pliable seals that maintain a position of the transfer tube 52 within the bore 46. The biasing members 62 suspend the transfer tube 52 within the bores 46 to define a conduit or fluid passage between cold plates 22, 24.

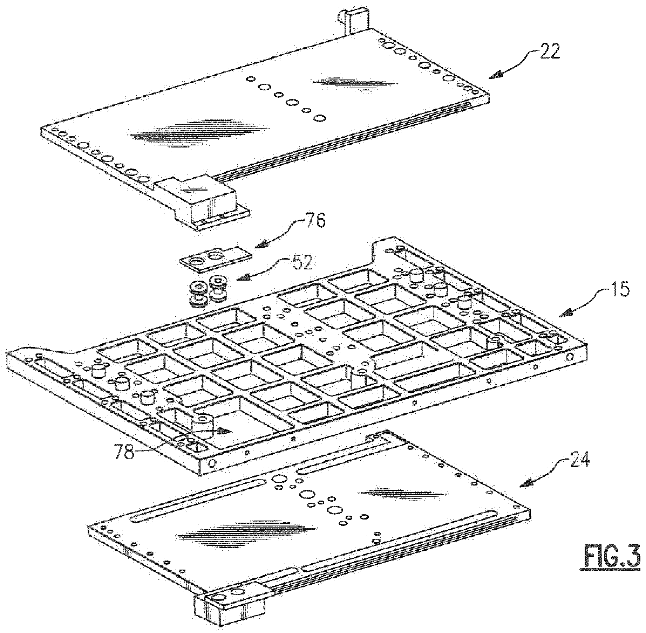

Referring to Figure 3 with continued reference to Figure 2, another example panel 15 includes an opening 78 for a shim member 76. The example shim member 76 defines the portion of the bore 46 that extends through the panel 15. The example panel 15 includes the bore features 46 provided as an integral feature. The panel 15 provides the bore 46 in the separate shim member 76. Separating the bore 46 from the panel 15 provides for the panel 15 structure to be simplified while still providing the required bore configuration.

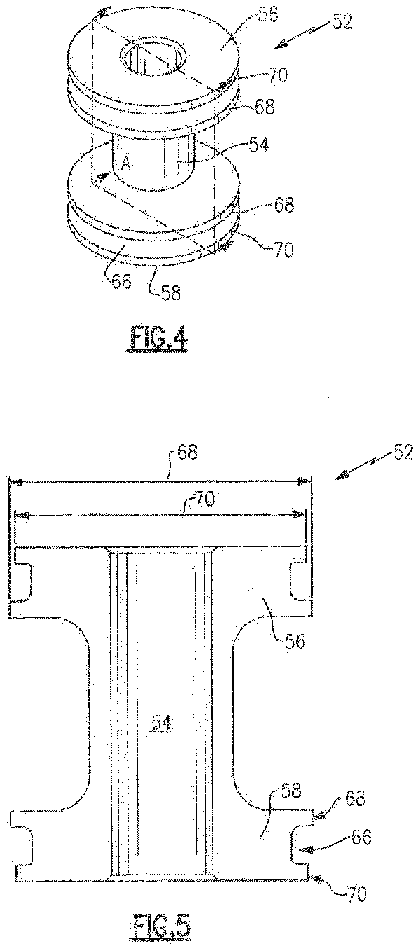

Referring to Figures 4 and 5 with continued reference to Figure 2, each of the transfer tubes 52 includes a central bore 54 that extends between a first flange 56 and a second flange 58. The first and second flanges 56, 58 include seals 60 that engage an inner surface of the bore 46. The biasing members 62 exert a biasing force on the transfer tube 52 to maintain it in a relative position within the bore 46. The example biasing members 62 comprise O-ring type seals that provide some sealing against leakage. However, the main operation of the example biasing member 62 is to provide and set a desired position between the bore portion 48 in the first cold plate 22 and the bore portion 50 in the second cold plate 24.

The example biasing members 62 exert a biasing force that is designed to maintain a position of the transfer tube 52 while allowing for relative movement between the cold plates 22 and 24 caused by vibration or other effects that might be encountered during operation.

Additional seals 64 are provided at the interface between the panel 16 and each of the cold plates 22, 24. The seals 64 provide a secondary seal that provides a backup to the seals 60, 62 disposed between the bore 46 and the transfer tube 52.

In this example, the first cold plate 22 is held to the second cold plate 24 by way of fasteners 72. The example fasteners 72 include a bolt extending through each cold plate 22, 24 and the panel 16 secured to a nut member. An alignment pin 74 is provided to align the panel 16 and the first cold plate 22 to the second cold plate 24. The alignment pin 74 further acts as a shear pin to minimize relative lateral movement between the cold plates 22, 24 and the panel 16. The alignment pin 74 accommodates loads that are perpendicular to the bore 54. The example alignment pin 74 can also be provided in different locations to provide the desired alignment between the first and second cold plates 22, 24. Alignment between the first and second cold plates 22, 24 also aligns the bore portions 48 and 50 that comprise the bore 46.

The example transfer tube 52 includes the first flange 56 and second flange 58. Each of the first flange 56 and second flange 58 includes an annular channel 66 that receives a sealing member 60. The annular channel 66 is disposed between a first diameter 70 disposed at ends of the transfer tube 52 and a second diameter 68 spaced apart from the ends of the transfer tube.

The second diameter 68 is greater than the first diameter 70. The difference between the first diameter 70 and the second diameter 68 accommodate tilting movement of the transfer tube 52. That is, the transfer tube 52 is disposed within the bore 46 such that it may compensate vibrational movement along the axis A. However, vibratory movement may also occur in a direction transverse to the axis A. The differences between the first diameter 70 and the second diameter 68 provide for a limited amount of tilting movement within the bore 46. Accordingly, the transfer tube 52 is capable of tilting relative to the axis A without becoming lodged within the bore 46 to maintain its ability to move along the axis A and accommodate vibratory movement between the relative parts.

Accordingly, the example transfer tube 52 of the cold plate assembly provides the desired fluid conduit between first and second cold plates 22 and 24 that is capable of accommodating high vibrational effects while maintaining the desired seal through a desired life cycle of the assembly.

Although an example embodiment has been disclosed, a worker of ordinary skill in this art would recognize that certain modifications would come within the scope of this disclosure. For that reason, the following claims should be studied to determine the scope and content of this invention.

## Claims

1. A cold plate assembly (14) comprising:
a support structure (16) including first (18) and second (20) opposing sides;
a first cold plate (22) disposed on the first side of the support structure (16);
a second cold plate (24) disposed on the second side (20) of the support structure (16);
each of the first and second cold plates (22,24) including passages (38,40) through which a cooling medium flows; and
a bore (46) defined within the first cold plate (22) and the second cold plate (24) and communicating with said passages (38,40) ; and **characterized by**
a transfer tube (52) movable within the bore (46) along an axis and extending through the support structure (16) for communicating fluid between the first cold plate (22) and the second cold plate (24), and first and second biasing members (62) disposed at opposite ends of the transfer tube (52) for holding the transfer tube (52) suspended within the bore in a desired position while accommodating vibrational movement along the axis.

2. The cold plate assembly as recited in claim 1, including first (56) and second (58) flanges disposed on opposing ends of the transfer tube (52), and including a first seal between the first flange (56) and the bore and a second seal between the second flange (58) and the bore.

3. The cold plate assembly as recited in claim 2, wherein each of the first flange (56) and the second flange (58) includes an annular channel (66) defined between a first outer diameter (70) at an end of the transfer tube (52) and a second outer diameter (68) spaced apart from the end of the transfer tube (52), the second outer diameter (68) is greater than the first outer diameter (70).

4. The cold plate assembly as recited in claim 1, wherein the bore extends partially through each of the first and second cold plates.

5. The cold plate assembly as recited in claim 1, wherein each of the first (22) and second (24) cold plates comprises passages for a cooling medium.

6. The cold plate assembly as recited in claim 1, including a shim defining a portion of the bore through the support structure.

7. The cold plate assembly as recited in claim 1, including first and second flanges (56, 58) disposed on opposing ends of the transfer tube (52).

8. The cold plate assembly, wherein the transfer tube (52) includes a central bore (54) extending between the first and second flanges (56, 58).

9. The cold plate assembly as recited in claim 7, wherein a first passage is defined within the first cold plate (22) and a second passage is defined within the second cold plate (24).

10. The cold plate assembly as recited in claim 5, wherein the transfer tube (52) communicates cooling medium through a support structure between the passages in the first cold plate and the passages in the second cold plate.

11. A method of assembling a a cold plate as defined in claim 1, the method comprising:
assembling a panel (16) including a first side (18) and a second side (20);
mounting a first cold plate (22) to the first side (18) of the panel;
mounting a second cold plate (24) to the second side (20) of the panel; each of the first and second cold plates (22,24) including passages (38,40) through which a cooling medium flows; Z
inserting a transfer tube (52) within a bore (46) defined within the panel (16), first cold plate (22) and the second cold plate (24, said bore (46) communicating with said passages (38,40), to create a passage for a cooling medium through the panel (16) between the first cold plate (22) and the second cold plate (24); and **characterized by**
suspending the transfer tube (52) in a desired position within the bore between first and second biasing members for holding the transfer tube (52) in a desired position while accommodating vibrational movement along the axis.

12. The method as recited in claim 11, including the step of sealing each end of the transfer tube to a portion of the bore corresponding to the first (22) and second (24) cold plates.

13. The method as recited in claim 11, including the step of defining a first diameter (70) of the transfer tube at opposing ends and a second diameter (68) spaced apart from the opposing end such that the second diameter (68) is greater than the first diameter (70).

## Patentansprüche

1. Kühlplattenanordung (14), umfassend:
eine Stützstruktur (16), die eine erste (18) und zweite (20) gegenüberliegende Seite beinhaltet;
eine erste Kühlplatte (22), die auf der ersten Seite der Stützstruktur (16) angeordnet ist;
eine zweite Kühlplatte (24), die auf der zweiten Seite (20) der Stützstruktur (16) angeordnet ist;
wobei jede von der ersten und zweiten Kühlplatte (22, 24) Durchgänge (38, 40) beinhaltet, durch die ein Kühlmedium strömt; und
wobei eine Bohrung (46) in der ersten Kühlplatte (22) und der zweiten Kühlplatte (24) definiert ist und mit den Durchgängen (38, 40) kommuniziert; und **gekennzeichnet durch**
eine Übertragungsröhre (52), die in der Bohrung (46) entlang einer Achse bewegt werden kann und sich durch die Stützstruktur (16) erstreckt, um Fluid zwischen der ersten Kühlplatte (22) und der zweiten Kühlplatte (24) zu kommunizieren, und wobei ein erstes und zweites Vorspannelement (62) an gegenüberliegenden Enden der Übertragungsröhre (52) angeordnet sind, um die Übertragungsröhre (52) in einer gewünschten Position in der Bohrung aufgehängt zu halten, während eine Schwingungsbewegung entlang der Achse ermöglicht wird.

2. Kühlplattenanordung nach Anspruch 1, beinhaltend einen ersten (56) und zweiten Flansch (58), die an gegenüberliegenden Enden der Übertragungsröhre (52) angeordnet sind und eine erste Dichtung zwischen dem ersten Flansch (56) und der Bohrung und eine zweite Dichtung zwischen dem zweiten Flansch (58) und der Bohrung beinhalten.

3. Kühlplattenanordnung nach Anspruch 2, wobei jeder von dem ersten Flansch (56) und dem zweiten Flansch (58) einen ringförmigen Kanal (66) beinhaltet, der zwischen einem ersten Außendurchmesser (70) an einem Ende der Übertragungsröhre (52) und einem zweiten Außendurchmesser (68) definiert ist, der von dem Ende der Übertragungsröhre (52) beabstandet ist, wobei der zweite Außendurchmesser (68) größer als der erste Außendurchmesser (70) ist.

4. Kühlplattenanordnung nach Anspruch 1, wobei sich die Bohrung teilweise durch jede von der ersten und zweiten Kühlplatte erstreckt.

5. Kühlplattenanordnung nach Anspruch 1, wobei jede von der ersten (22) und zweiten (24) Kühlplatte Durchgänge für ein Kühlmedium umfasst.

6. Kühlplattenanordnung nach Anspruch 1, beinhaltend eine Scheibe, die einen Abschnitt der Bohrung durch die Stützstruktur beinhaltet.

7. Kühlplattenanordnung nach Anspruch 1, beinhaltend einen ersten und zweiten Flansch (56, 58), die an gegenüberliegenden Enden der Übertragungsröhre (52) angeordnet sind.

8. Kühlplattenanordnung, wobei die Übertragungsröhre (52) eine zentrale Bohrung (54) beinhaltet, die sich zwischen dem ersten und zweiten Flansch (56, 58) erstreckt.

9. Kühlplattenanordnung nach Anspruch 7, wobei ein erster Durchgang in der ersten Kühlplatte (22) definiert ist und ein zweiter Durchgang in der zweiten Kühlplatte (24) definiert ist.

10. Kühlplattenanordnung nach Anspruch 5, wobei die Übertragungsröhre (52) ein Kühlmedium durch eine Stützstruktur zwischen den Durchgängen in der ersten Kühlplatte und den Durchgängen in der zweiten Kühlplatte kommuniziert.

11. Verfahren zum Zusammenbauen einer Kühlplatte nach Anspruch 1, wobei das Verfahren Folgendes umfasst:
Zusammenbauen eines Panels (16), das eine erste Seite (18) und eine zweite Seite (20) beinhaltet;
Montieren einer ersten Kühlplatte (22) auf der ersten Seite (18) des Panels;
Montieren einer zweiten Kühlplatte (24) auf der zweiten Seite (20) des Panels;
wobei jede von der ersten und zweiten Kühlplatte (22, 24) Durchgänge (38, 40) beinhaltet, durch die ein Kühlmedium strömt;
Einführen einer Übertragungsröhre (52) in eine Bohrung (46), die in dem Panel (16), der ersten Kühlplatte (22) und der zweiten Kühlplatte (24) definiert ist, wobei die Bohrung (46) mit den Durchgängen (38, 40) kommuniziert, um einen Durchgang für ein Kühlmedium durch das Panel (16) zwischen der ersten Kühlplatte (22) und der zweiten Kühlplatte (24) zu erzeugen; **gekennzeichnet durch**
Aufhängen der Übertragungsröhre (52) in einer gewünschten Position in der Bohrung zwischen einem ersten und zweiten Vorspannelement, um die Übertragungsröhre (52) in einer gewünschten Position zu halten, während eine Schwingungsbewegung entlang der Achse ermöglicht wird.

12. Verfahren nach Anspruch 11, beinhaltend den Schritt des Abdichtens jeden Endes der Übertragungsröhre an einem Abschnitt der Bohrung, welcher der ersten (22) und zweiten (24) Kühlplatte entspricht.

13. Verfahren nach Anspruch 11, beinhaltend den Schritt des Definierens eines ersten Durchmessers (70) der Übertragungsröhre an gegenüberliegenden Enden und eines zweiten Durchmessers (68), der von dem gegenüberliegenden Ende beabstandet ist, sodass der zweite Durchmesser (68) größer als der erste Durchmesser (70) ist.

## Revendications

1. Ensemble plaque froide (14) comprenant :
une structure de support (16) comportant des première (18) et seconde (20) faces opposées ;
une première plaque froide (22) disposée sur la première face de la structure de support (16) ;
une seconde plaque froide (24) disposée sur la seconde face (20) de la structure de support (16) ;
chacune des première et seconde plaques froides (22,24) comportant des passages (38, 40) à travers lesquels s'écoule un liquide de refroidissement ;
et
un alésage (46) défini à l'intérieur de la première plaque froide (22) et de la seconde plaque froide (24) et communiquant avec lesdits passages (38,40) ; et **caractérisé par**
un tube de transfert (52) mobile à l'intérieur de l'alésage (46) le long d'un axe et s'étendant à travers la structure de support (16) pour faire communiquer le fluide entre la première plaque froide (22) et la seconde plaque froide (24), et les premier et second éléments de sollicitation (62) disposés aux extrémités opposées du tube de transfert (52) pour maintenir le tube de transfert (52) suspendu à l'intérieur de l'alésage dans une position souhaitée tout en permettant un mouvement vibratoire le long de l'axe.

2. Ensemble plaque froide selon la revendication 1, comportant des première (56) et seconde (58) brides disposées sur des extrémités opposées du tube de transfert (52) et comportant un premier joint d'étanchéité entre la première bride (56) et l'alésage et un second joint d'étanchéité entre la seconde bride (58) et l'alésage.

3. Ensemble plaque froide selon la revendication 2, dans lequel chacune de la première bride (56) et de la seconde bride (58) comporte un canal annulaire (66) défini entre un premier diamètre externe (70) à une extrémité du tube de transfert (52) et un second diamètre externe (68) espacé de l'extrémité du tube de transfert (52), le second diamètre externe (68) est supérieur au premier diamètre externe (70).

4. Ensemble plaque froide selon la revendication 1, dans lequel l'alésage s'étend partiellement à travers chacune des première et seconde plaques froides.

5. Ensemble plaque froide selon la revendication 1, dans lequel chacune des première (22) et seconde (24) plaques froides comprend des passages pour un liquide de refroidissement.

6. Ensemble plaque froide selon la revendication 1, comportant une cale définissant une partie de l'alésage à travers la structure de support.

7. Ensemble plaque froide selon la revendication 1, comportant des première et seconde brides (56, 58) disposées sur des extrémités opposées du tube de transfert (52).

8. Ensemble plaque froide, dans lequel le tube de transfert (52) comporte un alésage central (54) s'étendant entre les première et seconde brides (56, 58).

9. Ensemble plaque froide selon la revendication 7, dans lequel un premier passage est défini à l'intérieur de la première plaque froide (22) et un second passage est défini à l'intérieur de la seconde plaque froide (24).

10. Ensemble plaque froide selon la revendication 5, dans lequel le tube de transfert (52) communique le liquide de refroidissement à travers une structure de support entre les passages dans la première plaque froide et les passages dans la seconde plaque froide.

11. Procédé d'assemblage d'une plaque froide selon la revendication 1, le procédé comprenant :
l'assemblage d'un panneau (16) comportant une première face (18) et une seconde face (20) ;
le montage d'une première plaque froide (22) sur la première face (18) du panneau ;
le montage d'une seconde plaque froide (24) sur la seconde face (20) du panneau ;
chacune des première et seconde plaques froides (22, 24) comportant des passages (38, 40) à travers lesquels s'écoule un liquide de refroidissement ;
l'insertion d'un tube de transfert (52) à l'intérieur d'un alésage (46) défini à l'intérieur du panneau (16), de la première plaque froide (22) et de la seconde plaque froide (24), ledit alésage (46) communiquant avec lesdites passages (38, 40), afin de créer un passage pour un liquide de refroidissement à travers le panneau (16) entre la première plaque froide (22) et la seconde plaque froide (24) ; et **caractérisé par**
la suspension du tube de transfert (52) dans une position souhaitée à l'intérieur de l'alésage entre les premier et second éléments de sollicitation pour maintenir le tube de transfert (52) dans une position souhaitée tout en permettant un mouvement vibratoire le long de l'axe.

12. Procédé selon la revendication 11, comportant l'étape de scellement de chaque extrémité du tube de transfert sur une partie de l'alésage correspondant aux première (22) et seconde (24) plaques froides.

13. Procédé selon la revendication 11, comportant l'étape de définition d'un premier diamètre (70) du tube de transfert aux extrémités opposés et d'un second diamètre (68) espacé de l'extrémité opposée de sorte que le second diamètre (68) est supérieur au premier diamètre (70).
